# EUROPÄISCHE PATENTSCHRIFT

(11) **EP 2 773 970 B1**
(45) Veröffentlichungstag und Bekanntmachung des Hinweises auf die Patenterteilung: **14.10.2015**
(21) Anmeldenummer: 12790810.1
(22) Anmeldetag: 02.11.2012
(51) Int. Cl.: G01P 15/08

(54) **BAUELEMENT UND VERFAHREN ZUR HERSTELLUNG EINES BAUELEMENTS**
COMPONENT AND METHOD FOR PRODUCING A COMPONENT
COMPOSANT ET PROCÉDÉ DE FABRICATION D'UN COMPOSANT

(30) Priorität: 03.11.2011 DE 102011085723
(43) Veröffentlichungstag der Anmeldung: 10.09.2014
(73) Patentinhaber: Continental Teves AG & Co. oHG, 60488 Frankfurt (DE)
(72) Erfinder: GÜNTHNER, Stefan, 60489 Frankfurt am Main (DE); SCHMID, Bernhard, 61169 Friedberg (DE)
(86) Internationale Anmeldenummer: PCT/EP2012/071721
(87) Internationale Veröffentlichungsnummer: WO 2013/064632

(56) Entgegenhaltungen:
- EP-A2- 1 167 979
- US-A1- 2008 136 000
- US-A1- 2010 028 618

## Beschreibung

Die vorliegende Erfindung betrifft ein Bauelement nach Anspruch 1 und ein Verfahren zur Herstellung eines Bauelementes nach Anspruch 8.

Unter einem Bauelement wird eine Einheit verstanden, das eine bestimmte Funktion bereitstellt. Hierbei können Dioden, Transistoren, Sensoren eine Einheit bilden, um mechanische wie auch elektrische Messaufgaben bereitzustellen. Bauelemente können Elektroden aufweisen, um in einer größeren Einheit, wie einer elektrischen Schaltung, betrieben werden zu können. Ein Bauelement kann auch in Form einer integrierten Schaltung auf einem Chip bereitgestellt werden. Hierbei können mikromechanischen Strukturen ausgebildet sein, beispielsweise auf einem Substrat, das mit Hilfe von Ätzverfahren definiert wird. Gattungsähnliche Bauelemente sind aus den Druckschriften US 2008 136 000, US 2010 028 618 und EP 1 167 979 bekannt.

Heutezutage werden verschiedene Typen von mikromechanischen Sensoren, insbesondere Inertialsensoren, wie Drehraten- und Beschleunigungssensoren, überwiegend auf unterschiedlichen Substraten hergestellt. Es werden somit unterschiedliche Bauelemente bereitgestellt, um unterschiedliche Messaufgaben zu lösen.

Zur Herstellung von derartigen elektrischen, mechanischen oder elektro-mechanischen Bauelementen kommen Verfahren und Technologien zum Einsatz, die typischerweise in der Halbleiterindustrie aufzufinden sind. Ein Grund für die separate Herstellung der verschiedenen Sensoren liegt in den unterschiedlichen physikalischen Anforderungen solcher Sensoren. Somit werden unterschiedliche Sensortypen auf unterschiedliche Weisen hergestellt.

Ein Sensortyp ist beispielsweise ein Drehratensensor. Drehratensensoren werden häufig unter Vakuum hermetisch verkapselt, damit sie durch unterkritisch gedämpfte resonante Anregung hohe Schwingungsamplituden erzielen, beispielsweise mit einer Güte Q > 0,5. Hierbei wird jedoch gleichzeitig eine geringe elektrische Antriebsleistung bereitgestellt.

Ein weiteres Beispiel für einen Sensortyp ist ein Beschleunigungssensor. Beschleunigungssensoren im Vergleich zu Drehratensensoren hingegen stellen üblicherweise eine überkritisch gedämpfte Struktur dar, beispielsweise mit einer Güte Q < 0,5. Typischerweise sind Beschleunigungssensoren aus Massenschwingern aufgebaut, wobei die Massenschwinger auf niederfrequente Beschleunigungen reagieren. Die Relation zwischen Beschleunigung und Massenauslenkung eines Beschleunigungssensors sollte dabei weitestgehend linear sein und keine resonanten Überhöhungen aufweisen. Eine unterkritische Dämpfung kann hierbei auch zu Fehlmessungen führen. Dies ist der Fall, wenn höherfrequente Störungen in der Nähe der Eigenresonanzen des Beschleunigungsaufnehmers auf den Sensor wirken, so dass seismischen Massen des Beschleunigungssensors in ihren Resonanzfrequenzen zu Schwingungen mit großen Amplituden anregt werden. Dies kann zu hohen Ausgangssignalen führen, die nachgeschaltete Ausgangsfilter nicht mehr ausreichend dämpfen können.

Drehratensensoren und Beschleunigungssensoren werden oft für eine Messaufgabe gleichzeitig benötigt, beispielsweise bei einer elektronischen Stabilitätsregelung (ESP) oder bei einem Überrollschutz in Kraftfahrzeugen.

Bisher wurden verschiedene Methoden zur Bereitstellung dieser beiden Sensortypen vorgeschlagen:
Eine Möglichkeit ist eine Verkapselung beider Strukturen des Drehratensensors und des Beschleunigungssensors auf einem Chip in einer gemeinsamen Kavität unter Vakuum bereitzustellen, wobei der Beschleunigungssensor durch elektrische Methoden künstlich höher bedämpft wird.

Dieses Vorgehensweise hat die Nachteile, dass zu den eigentlichen Messwandlerstrukturen zusätzliche Strukturen in den Beschleunigungssensor integriert werden müssen, welche die Größe des Sensors erhöhen. Ebenso müssen zusätzliche elektronische Schaltungsblöcke in die Signalverarbeitung (beispielsweise eine anwendungsspezifische integrierte Schaltung (ASIC= Application Specific Integrated Circuit) integriert werden, was die Chipgröße eines Integrated Circuit (=IC) ebenso erhöht. In beiden Fällen werden durch die erhöhten Chipgrößen die Herstellungskosten pro Chip gesteigert. Somit werden die Kostenvorteile einer Integration beider Sensortypen auf einem Chip ausgeglichen oder sogar ins Negative gewandelt.

Eine weitere Möglichkeit zur Bereitstellung von verschiedenen Sensortypen besteht darin, eine Verkapselung beider Sensorstrukturen auf einem Chip in einer gemeinsamen Kavität unter definiertem Druck bereitzustellen, wobei der Beschleunigungssensor überkritisch bedämpft wird. Hierbei kann durch erhöhte Antriebsleistung und vermehrte Antriebsstrukturen innerhalb der Drehratensensorstruktur die notwendige Schwingungsamplitude eingestellt werden.

Bei dieser Vorgehensweise werden durch die vermehrte Anzahl der Antriebsstrukturen die Chipfläche des Drehratensensors und die Chipfläche des ASIC durch die Bereitstellung der höheren Antriebsleistung vergrößert.

Zur Bereitstellung einer Kombination von zwei Sensoren besteht ferner eine weitere Möglichkeit darin, eine Verkapselung beider Sensorstrukturen auf einem Chip unter Vakuum bereitzustellen, wobei der Beschleunigungssensor in einer vom Drehratensensor separaten Kavität untergebracht ist, welche eine Belüftungsöffnung aufweist. Diese Belüftungsöffnung wird beispielsweise nach dem Verkapseln unter dem für den Beschleunigungssensor notwendigen Druck in einem weiteren Verfahrensschritt hermetisch verschlossen.

Um die Belüftungsöffnung unter gezielt eingestelltem Druck zu verschließen, sind homogene Schichtabscheidungen bekannt, die den gesamten Wafer als ganzes verschließen. Dies wird beispielsweise unter Anwendung von Sputtern oder Gasphasenabscheidungen, wie Chemical Vapour Deposition (=CVD), Plasma-enhanced chemical vapor deposition (=PECVD), Low Pressure CVD (=LPCVD), etc. bereitgestellt. Diese Verfahren benötigen zum zuverlässigen vakuumdichten Verschluss der Belüftungsöffnung jedoch Unterdruck, was den einzustellenden maximalen Druck begrenzt. Auch ist die verkapselte Struktur vor dem Eindringen der Schichten in die Kavität zu schützen. Ferner werden hohe prozesstechnische Anforderungen bei der Herstellung gestellt, damit der Verschluss der Belüftungsöffnung nicht durch Partikel oder unzureichendes Schichtwachstum verhindert wird. Ferner lassen sich auch die Belüftungsöffnung durch Dispensen von Verschlussmaterial verschließen. Dies hat jedoch den Nachteil, dass jeder Chip einzeln verschlossen werden muss und die Verschlussmaterialien hermetisch Vakuumdicht sein müssen.

Insgesamt sind die bisher bekannten Verfahren sehr kostenintensiv.

Es ist Aufgabe der Erfindung, mindestens zwei mikromechanische Strukturen in einem Bauelement bereitzustellen bei gleichzeitig kostengünstiger Herstellung des Bauelements.

Die Aufgabe wird durch die Merkmale der unabhängigen Ansprüche gelöst. Bevorzugte Weiterbildungen der Erfindung sind Gegenstand der abhängigen Ansprüche.

Der Erfindung liegt der Gedanke zugrunde, ein Bauelement und ein Verfahren zur Herstellung des Bauelements bereitzustellen, wobei die Integration von mikromechanischen Strukturen in einem Substrat bereitgestellt werden und die mikromechanischen Strukturen unter verschiedenen atmosphärischen Bedingungen betrieben werden können. Das Substrat ist beispielsweise Teil eines Mikrochips, der in beliebiger Umgebung, beispielsweise in Fahrzeugen, eingesetzt werden kann. Als Fahrzeuge kommen insbesondere Kraftfahrzeuge in Frage, bei denen verschiedene Messaufgaben benötigt werden, um beispielsweise eine Airbagauslösung oder eine Antriebsregelung bereitzustellen.

Es können hierbei zwei mikromechanische Strukturen in jeweils einer Kavität bereitgestellt werden. Diese mikromechanischen Strukturen können unterschiedliche Sensortypen in einem Bauelement sein. Hierbei können die beide Sensortypen mit denselben mikromechanischen Technologien hergestellt weden, was eine gleichzeitige Fertigung auf einem Substrat möglich macht. Durch die Verwendung eines Kanals, also einer Öffnung mit einer Zuführung, kann ein zweiter Druck unabhängig von einem ersten Druck in einer Kavität eingestellt werden, ohne dass es notwendig ist, einen Unterdruck vor dem Verschließen zu erzeugen.

Vorteilhaft ist hierbei eine Reduzierung der Fertigungskosten der Substrate. Beispielsweise wird als Substrat ein Silizium-Wafer verwendet. Es wird hierbei ein einzelner Produkttyp gefertigt, so dass nur ein Bauelement oder Chip anstatt zwei Bauelemente oder Chip in ein Package assembliert wird und in den Kalibrier- und Testprozessen als eine Einheit bearbeitet wird. Dies vereinfacht den Fertigungsprozess wie auch die Qualitätssicherung des Bauelementes. Nach Herstellung und Prüfung kann das Bauelement in eine elektronische Schaltung integriert werden, z. B. auf ein Printed Circuit Board (=PCB). Bei der Verwendung eines Bauteils anstelle einer Mehrzahl von Bauteilen kann der Raumbedarf und Montageaufwand verringert werden.

Die Herstellung des erfindungsgemäßen Bauteils kann mit Bondprozessen durchgeführt werden. Hierbei können herkömmliche Wafer-Substrate und herkömmliche Bondprozesse verwendet werden, die aus der Mikrosystemtechnik bekannt sind. Auf diese Weise können kostengünstig und zuverlässig die erfindungsgemäßen Bauelemente hergestellt werden. Somit wird erfindungsgemäß eine einfache und kostengünstige Integration von Strukturen auf einem Substrat bereitgestellt, die unter unterschiedlichen atmosphärischen Bedingungen, insbesondere unter unterschiedlichen Drücken, betrieben werden.

Es gibt mehrere Möglichkeiten für die Herstellung der erfindungsgemäßen Bauelemente. Es werden hierbei mikromechanische Elemente bereitgestellt, die auf einem Substrat, beispielsweise einem Chip, jeweils einem Gasdruck ausgesetzt, wobei die Gasdrücke unterschiedlich sein können. Hierbei schließt eine erste Kavität einen ersten Gasdruck ein und eine zweite Kavität schließt einen zweiten Gasdruck ein, wobei innerhalb der Kavitäten jeweils die mikromechanischen Elemente oder Sensoren angeordnet sind. Die Kavitäten sind hierbei voneinander hermetisch getrennt angeordnet.

Das Herstellungsverfahren sieht vor, dass das die mikromechanischen Elemente eines Wafers mit dem gewünschten ersten Gasdruck bereits hermetisch verkapselt sind, während alle weiteren mikromechanischen Elemente desselben Wafers mit dem gewünschten zweiten Gasdruck noch einen Kanal zum Gasaustausch oder Luftaustausch mit der Umgebung aufweisen. Dieser Kanal kann in der vorangegangenen Prozessfolge oder Verfahrensschritt an beliebiger Stelle beispielsweise auf Substratebene oder Waferebene durch nass- oder trockenätztechnische Verfahren hergestellt werden. Austrittsöffnungen der Kanäle der mikromechanischen Elemente innerhalb des zweiten Gasdrucks liegen dabei auf derselben Seite des Substrats oder Waferverbundes. Dies vereinfacht das Fertigungsverfahren.

Die Verkapselung der mikromechanischen Elemente mit dem ersten Gasdruck kann in der vorangegangenen Prozessfolge oder als Verfahrenschritt an beliebiger Stelle beispielsweise mithilfe von Waferbondverfahren geschehen. Bei der hermetischen Verkapselung der mikromechanischen Elemente, die mit dem ersten Gasdruck umgeben sind, kann mit üblichen Methoden der gewünschte erste Gasdruck eingestellt werden.

Zusätzlich werden die weiteren mikromechanischen Elemente mit dem zweiten Gasdruck auf Waferebene mittels eines Waferbondprozesses verkapselt. Dabei wird bei einem Waferbonder der gewünschte Gasdruck gewählt, unter dem die mikromechanischen Elemente mit dem zweiten Gasdruck verschlossen werden sollen. Hierbei kann ein sogenannter Verschlusswafer dauerhaft auf die Seite des Waferverbundes gebondet werden, auf der die Austrittsöffnungen der Kanäle der mikromechanischen Elemente mit dem zweiten Gasdruck liegen. Durch die Verwendung eines Kanals ist es möglich, in unterschiedlichen Substratschichten des Bauelementes Öffnungen zu verschließen, so dass während der Herstellung des Bauelements keine weiteren Maßnahmen getroffen werden brauchen, um einen Druck in einer Kavität einzustellen in der der jeweilige Kanal mündet.

Weiterbildungen des Verfahrens können Verfahrensschritte sein, die die Merkmale der angegebenen Bauelemente gemäß den Unteransprüchen sinngemäß realisieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Es zeigen:
Fig. 1 bis Fig. 8 ein erstes Ausführungsbeispiel zur Herstellung einer mikromechanischen Struktur gemäß der Erfindung; und
Fig. 9 bis Fig.14 ein zweites Ausführungsbeispiel zur Herstellung einer mikromechanischen Struktur gemäß der Erfindung.

Es werden hierbei für identische oder ähnliche Elemente in den Figuren gleiche Bezugszeichen verwendet.

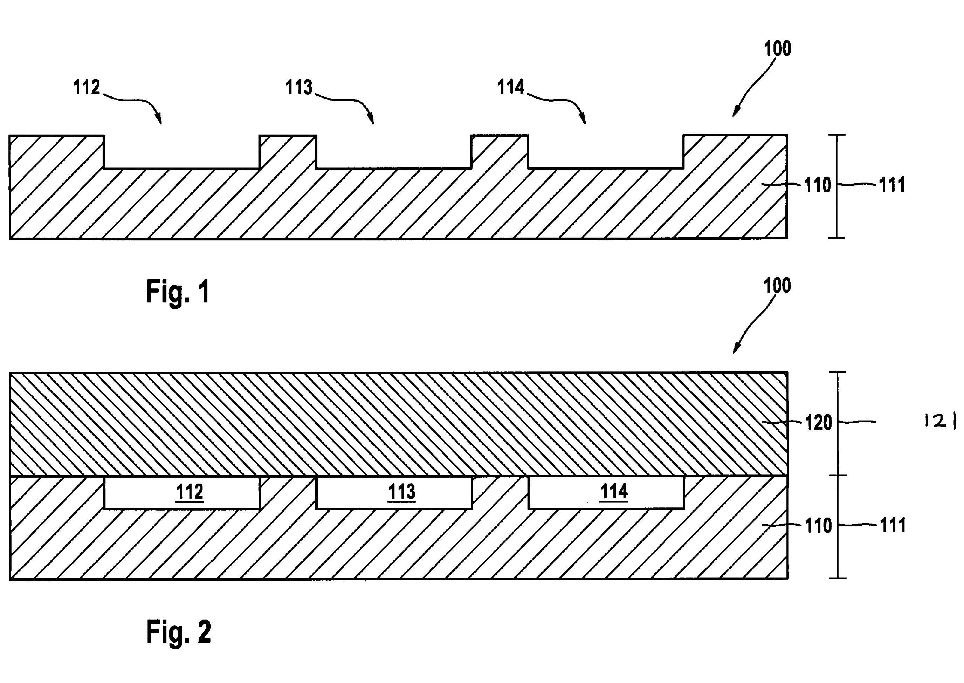

In den folgenden Figuren 1 bis 14 werden Aspekte beschrieben, welche auf Basis von Silizium-Mikromechanik Prozessen oder Verfahrensschritten bereitgestellt werden. Es können auch andere Technologien verwendet werden, bei denen lokal begrenzte Durchdringungen im Substrat und vakuumhermetische Substrat-zu-Substrat Verbindungstechnologien möglich sind.

Fig. 1 bis Fig. 8 zeigen ein erstes Ausführungsbeispiel zur Herstellung einer mikromechanischen Struktur gemäß der Erfindung.

Fig. 1 zeigt ein Substrat 100. In einem einen Trägerwafer 110 mit einer ersten Höhe 111, hier einem Siliziumwafer, werden für jede Struktur, welche unter einem separaten Gasdruck eingeschlossen werden soll, voneinander getrennte Kavitäten 112, 113, 114 eingebracht, wie in Fig. 1 dargestellt.

Danach werden an dem Substrat 100 mittels vakuumhermetischer Waferbondverfahren, beispielsweise Hoch- bzw. Niedertemperatur-Fusions-Bonden oder einem anodischem Waferbonden, die Kavitäten 112, 113, 114 mit einem weiteren Siliziumwafer 120 der Höhe 121 verschlossen, wobei der zweite Wafer 120 als Strukturwafer dient. Der Aufbau der beiden übereinander liegenden Wafer 110, 120 mit eingeschlossenen Kavitäten 112, 113, 114 wird anhand von Fig. 2 verdeutlicht.

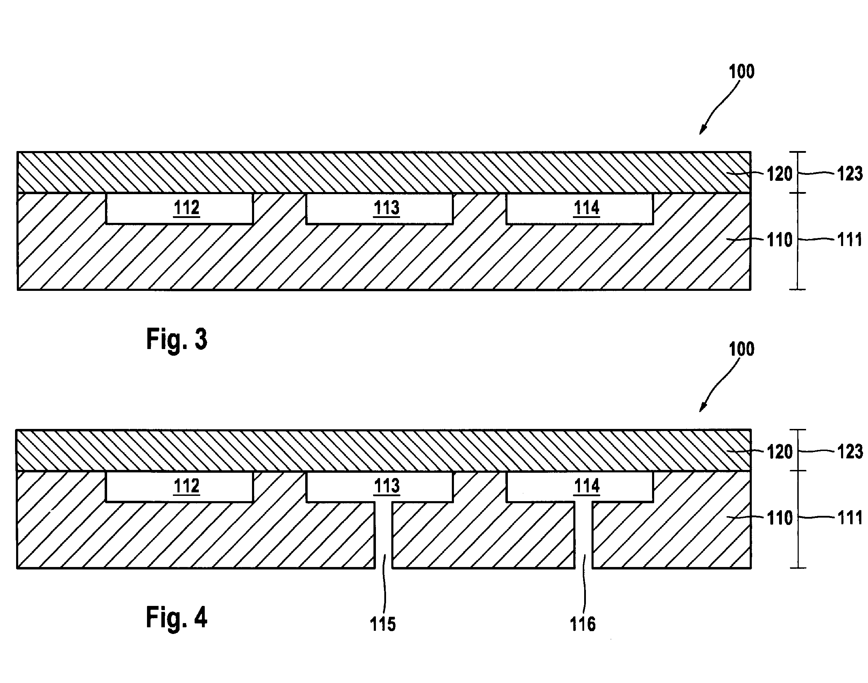

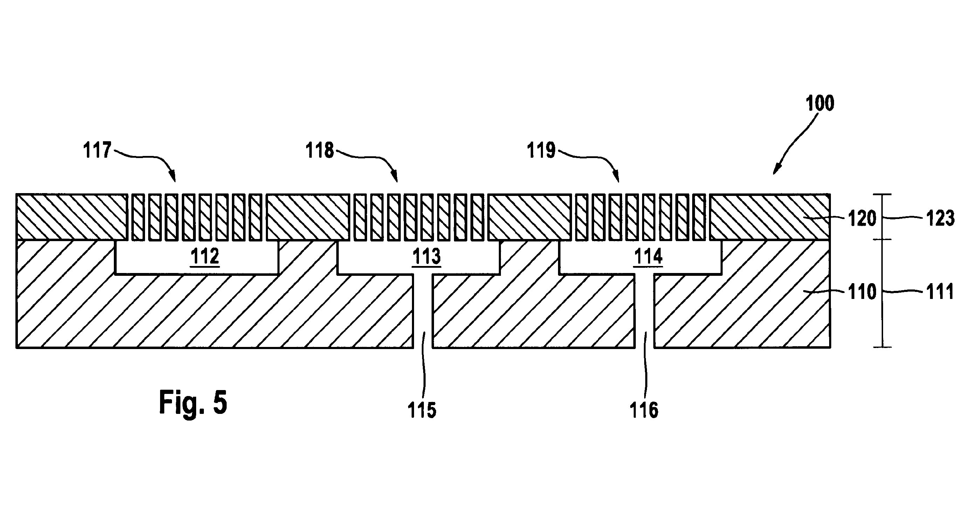

Fig. 3 zeigt, wie der Strukturwafer 120 anschließend auf eine notwendige Dicke gedünnt wird, d.h. seine ursprüngliche Höhe 121 wird auf eine Höhe 123 verringert. Nun werden von der Kavitätenseite her mittels anisotroper Ätzverfahren Kanäle 115, 116 in den Wafer 110 oder den unteren Bereich der Struktur 100 geätzt, wie in Fig. 4 gezeigt. Hierbei reichen die Kanäle 115, 116 jeweils bis in diejenigen Kavitäten 113, 114, welche einen von dem ersten Gasdruck in der ersten Kavität 112 unterschiedlichen Druck aufweisen sollen. In den gedünnten Strukturwafer 120 wird nun mittels anisotroper Strukturierungsverfahren, wie beispielsweise Trockenätzen mittels Deep reactive-ion etching (=DRIE), Ätzen mittels Kalilauge (=KOH Lauge) etc., die eigentliche Struktur 117, 118, 119 ausgeprägt, wie in Fig. 5 gezeigt. Diese Strukturen 117, 118, 119 dienen als mikromechanische Strukturen von Sensoren.

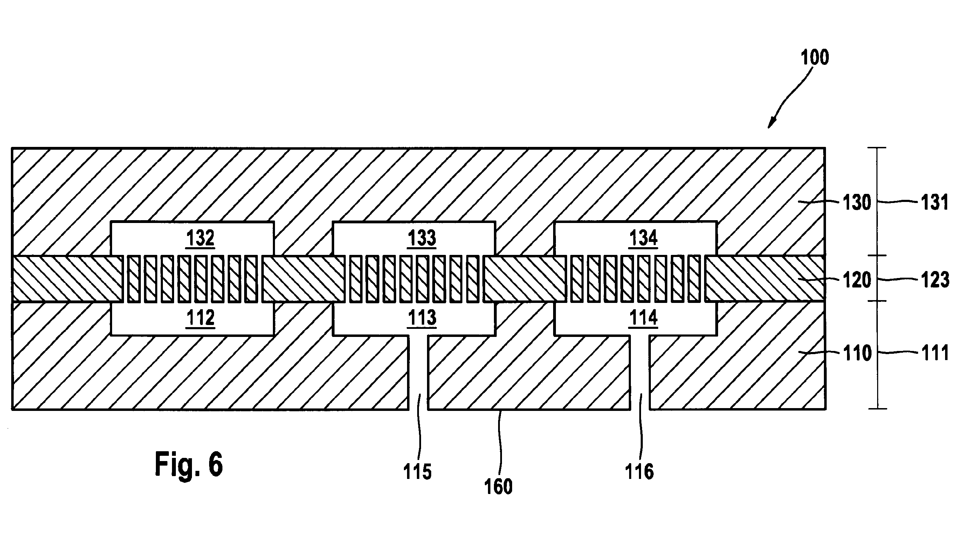

In Fig. 6 werden die Strukturen 117, 118, 119 nun mit einem weiteren Wafer 130 mit einer Höhe 131, auch als Deckel-Wafer bezeichnet, vakuumhermetisch verschlossen. Dieser Deckel-Wafer 130 weist wiederum für jede Struktur 117, 118, 119 eigene Kavitäten 132, 133, 134 auf. Alternativ werden die Strukturen 132, 133, 134 in dem Strukturwafer 120 über eine Vertiefung zurückgesetzt, so dass der Deckel-Wafer 130 plan auf den Strukturwafer 120 aufgebracht werden kann.

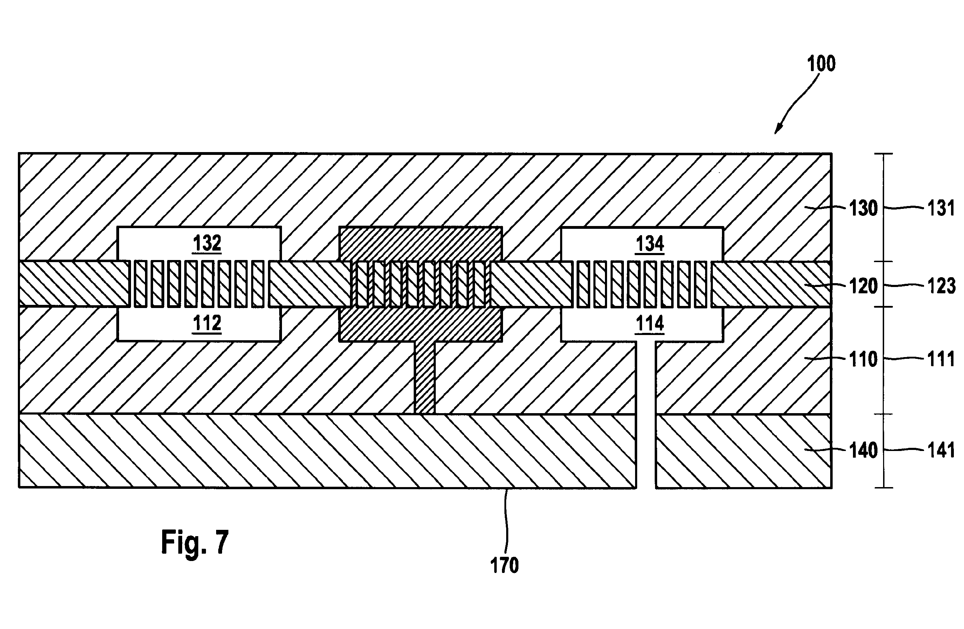

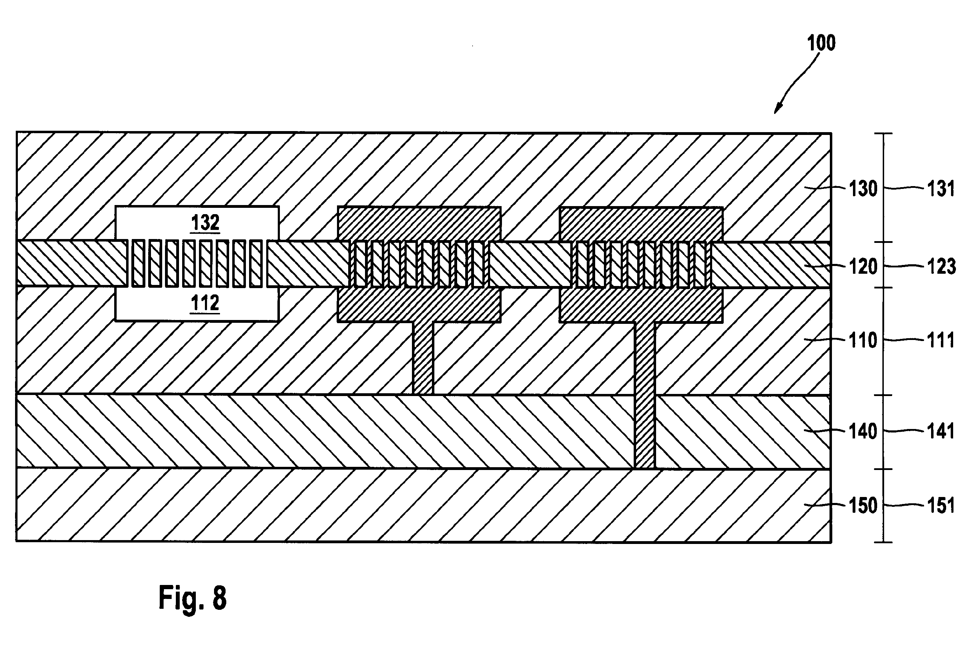

Anschließend wird auf den Trägerwafer 110 ein weiterer Wafer 140 mit einer Höhe 141, auch als Verschluss-Wafer bezeichnet, unter einem von dem ersten Gasdruck unterschiedlichen Druck gebondet, wie in Fig. 7 dargestellt. Sollen weitere vom ersten und zweiten Gasdruck verschiedene Drücke eingestellt werden, so weist der Verschlusswafer 140 Kanäle auf an den Stellen, an denen bereits der Trägerwafer 110 Verbindungskanäle zu den entsprechenden Elementen 114, 119, 134 aufweist. Ein zweiter Verschlusswafer 150 mit einer Höhe 151 kann zum Einschluss des gewünschten dritten Gasdrucks gegen den ersten Verschlusswafer 140 gebondet werden, wie in Fig. 8 gezeigt.

Die dargestellte Vorgehensweise kann nun für beliebig verschiedene Gasdrücke wiederholt werden. Hierbei kann vorgesehen sein, dass Verschlusswafer gemäß technologischen Bedingungen gedünnt werden, um die Dicke des Gesamtaufbaus zu reduzieren. Eine Reduzierung der Gesamtwaferhöhe kann beispielsweise mittels Schleifen, Polieren und/oder chemischmechanisches Polieren (=CMP) vorgesehen werden, beispielsweise auf Dicken kleiner etwa 20µm.

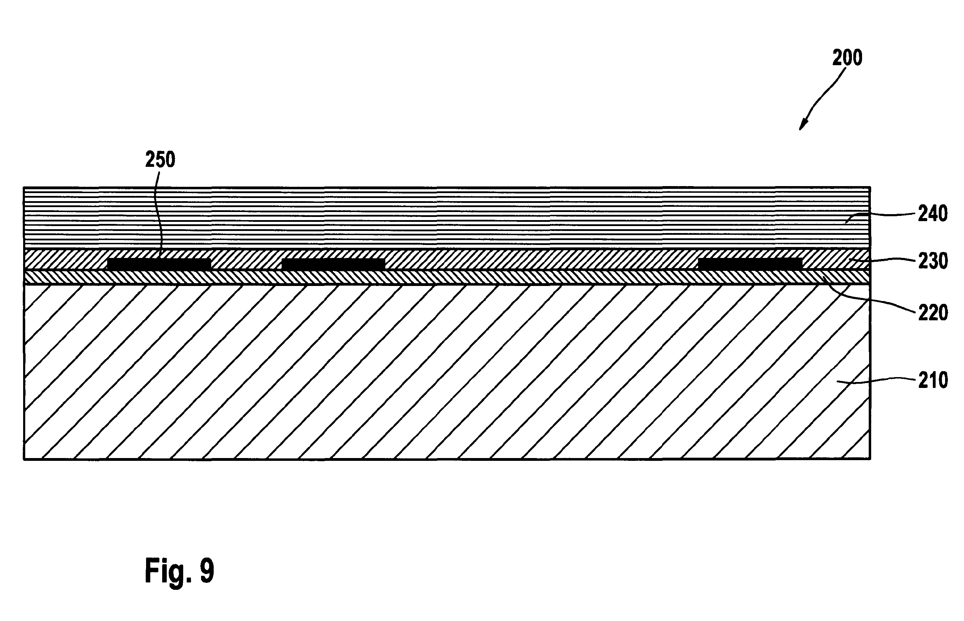

Fig. 9 bis Fig.14 zeigen ein zweites Ausführungsbeispiel zur Herstellung einer mikromechanischen Struktur gemäß der Erfindung.

Fig. 9 zeigt einen Schichtaufbau eines Substrats 200 mit einem Bodenwafer 210, einer ersten Einbettungsschicht 220, einer zweiten Einbettungsschicht 230, einer Strukturlage oder einem Strukturwafer 240 und einer eingebetteten leitfähigen Elektrodenschicht 250. Hierbei können die erste Einbettungsschicht 220 und die zweite Einbettungsschicht 230 jeweils isolierende Eigenschaften aufweisen und durch jeweils ätztechnische Verfahren entfernt werden.

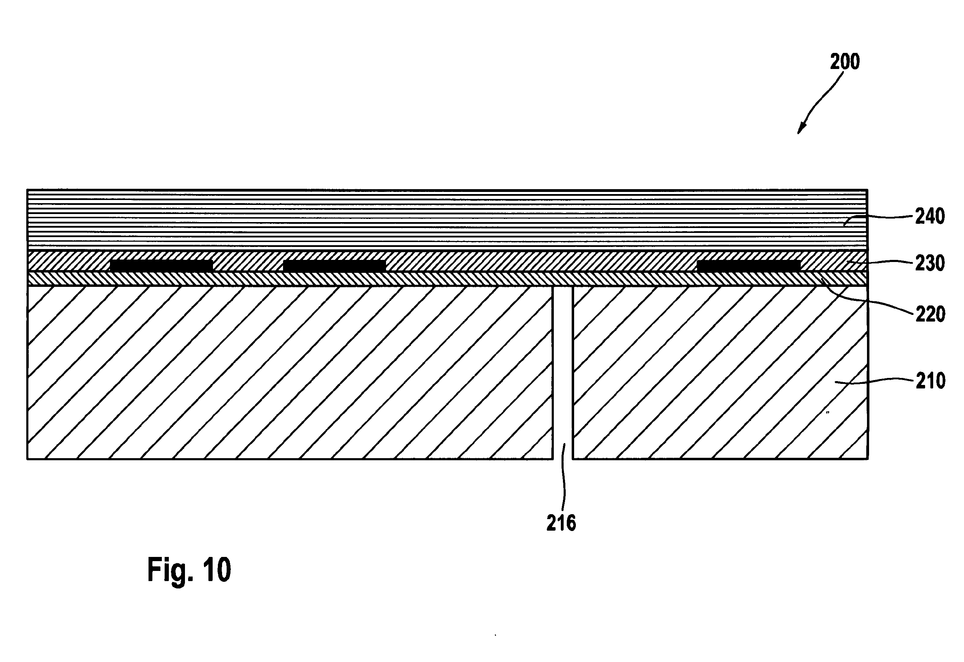

In den Bodenwafer 210 kann dann beispielsweise mit einem Trocken- oder Nassätzverfahren eine Öffnung oder ein Kanal 216 an vorbestimmten Stellen angeordnet werden, so dass sich eine Verbindung zu Elementen innerhalb einer zu erzeugenden Kavität 213 ergibt, deren Druck erst zeitlich später eingestellt wird. Diese Geometrie wird in Fig. 10 verdeutlicht.

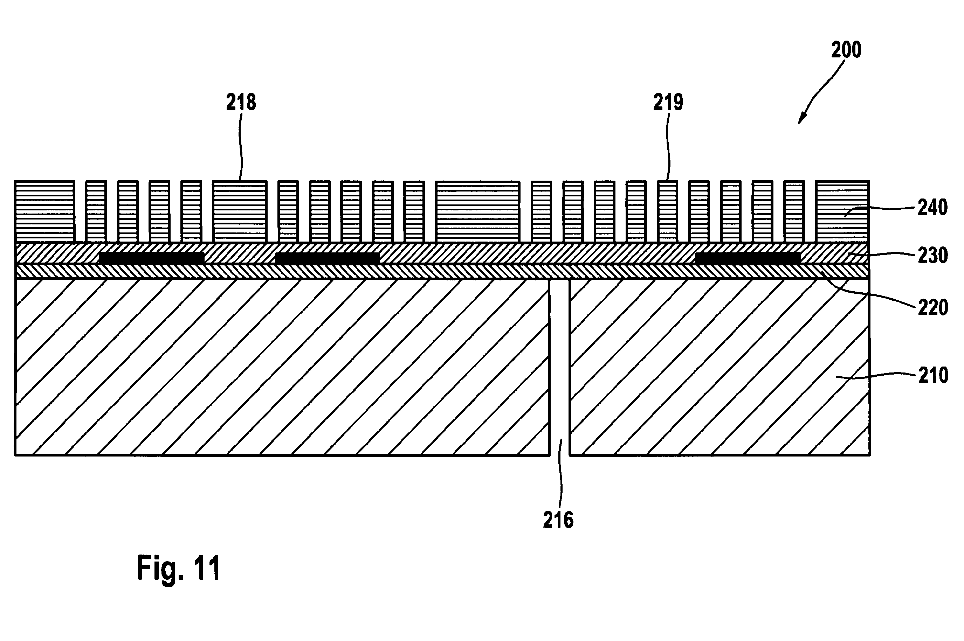

Danach werden, wie in Fig. 11 gezeigt, in der Strukturlage, bzw. im Strukturwafer 240 mikromechanische Geometrien 218, 219, wie Masse-Feder-Systeme, durch übliche mikromechanische Ätztechniken bereitgestellt. Diese Masse-Feder-Systeme 218, 219 sind zunächst noch mechanisch mit der Einbettungsschicht 230 verbunden. Damit die mikromechanischen Strukturen frei beweglich sind, werden noch die Einbettungsschichten 220 und 230 entfernt, die beispielsweise aus Siliziumdioxid gefertigt sein können. Das Entfernen kann beispielsweise mittels nasschemischer Ätzung erfolgen, so dass einerseits mikromechanische Strukturen 218, 219 frei beweglich sind, andererseits aber immer noch mechanische Verankerungen der mikromechanischen Strukturen 218, 219 auf dem Bodenwafer 210 bestehen bleiben.

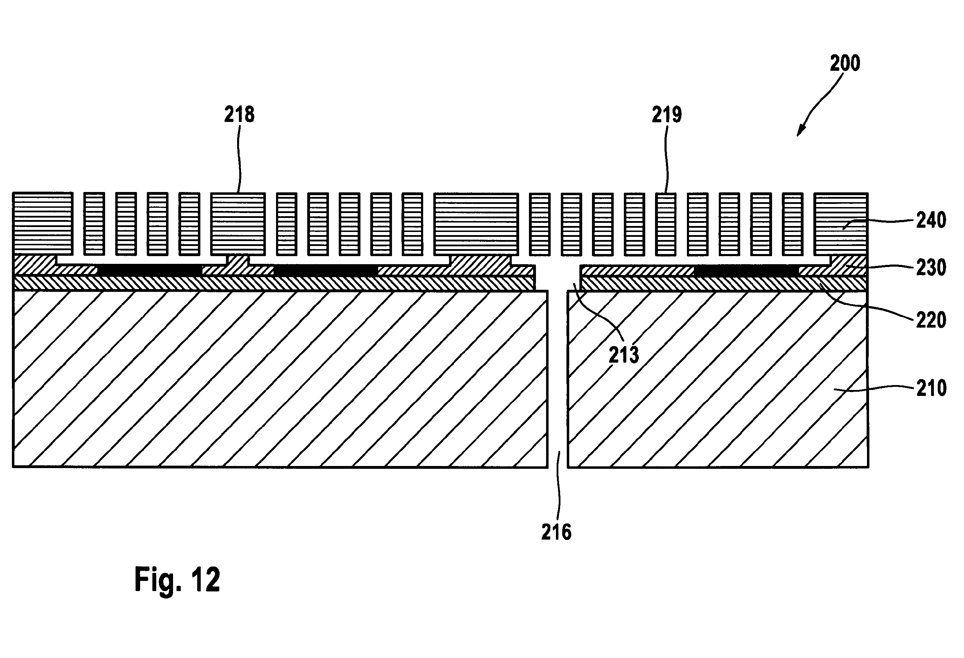

Ferner wird durch die Entfernung der Einbettungsschichten 220 und 230 gleichzeitig der durch die Einbettungsschichten 220 und 230 an seinem einen Ende verschlossene Verbindungskanal 216 geöffnet, wie in Fig. 12 dargestellt. Es entsteht auf diese Weise eine Kavität 213 am Ende des Kanals 216.

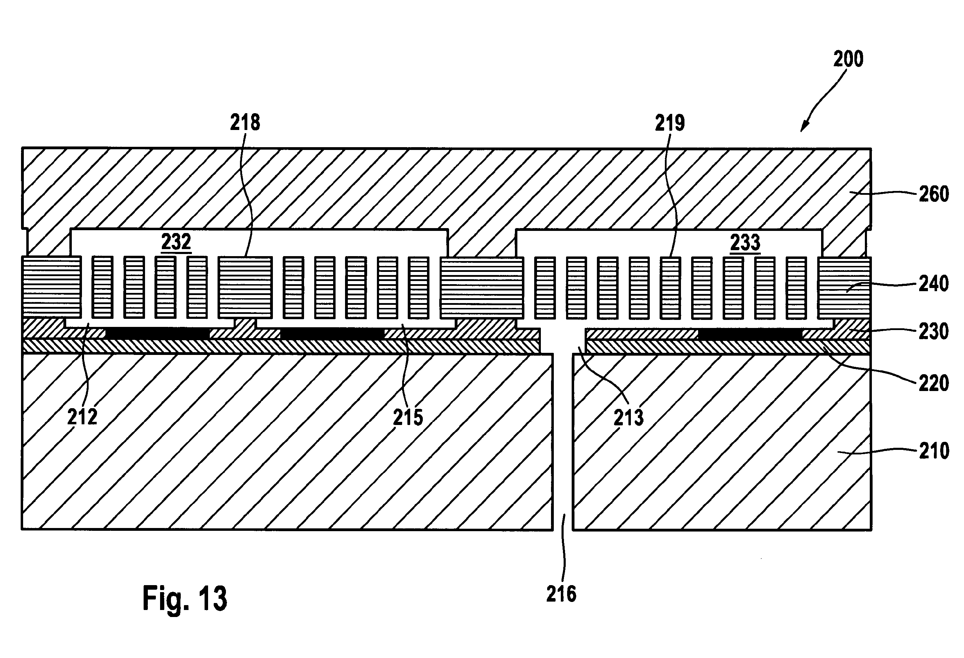

Danach können die Elemente 218 und daran anschließende Kavitäten 212, 215, 232 unter dem gewünschten Druck hermetisch verschlossen werden, indem beispielsweise ein Deckelwafer 260 durch ein Waferbondverfahren auf den Waferverbund aufgebracht wird. Die Elemente 219 und Kavitäten 213, 233 sind weiterhin über den Kanal 216 mit der Umgebung verbunden, wie Fig. 13 zeigt.

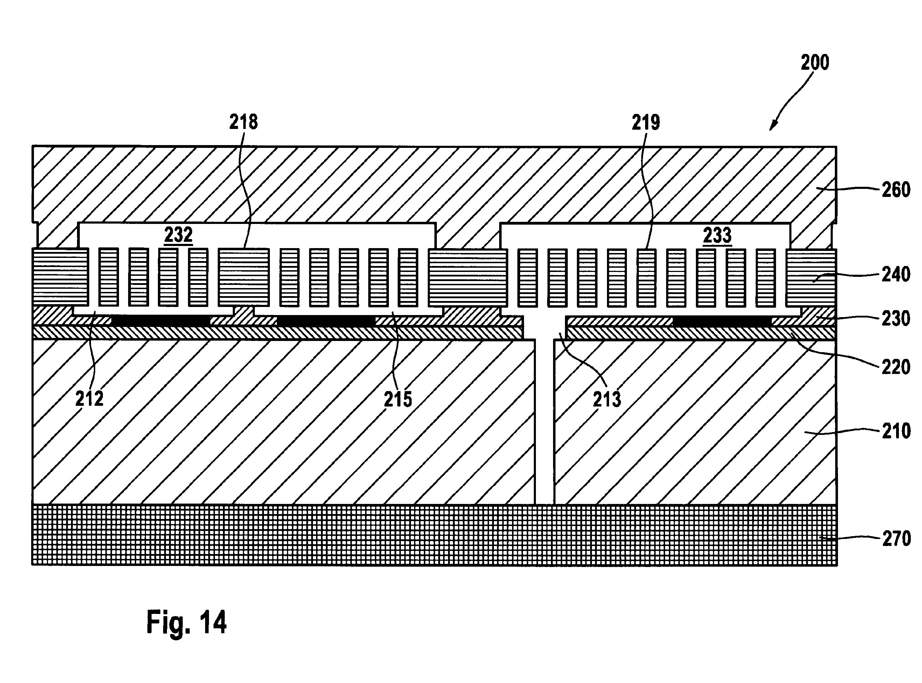

Schließlich kann ebenfalls über ein Waferbondverfahren ein Verschlusswafer 270 unter einem bestimmten Druck so mit dem Waferstapel verbunden werden, dass der Kanal 216 der Elemente 219 und Kavitäten 213, 233 hermetisch verschlossen wird und sich dort ein gewünschte Druck einstellt, wie Fig. 14 darstellt.

### Bezugszeichenliste:

erstes Ausführungsbeispiel Fig. 1 bis 9:
- 100: Substrat
- 11, 112, 113: Höhe
- 110, 120, 130, 140: Wafer-Schicht
- 112, 113, 114, 132, 133, 134: Kavität
- 115, 116: Kanal
- 117, 118, 119: mikromechanische Struktur
zweites Ausführungsbeispiel Fig. 10 bis 14:
- 200: Struktur
- 210: Bodenwafer
- 212, 213, 215, 232, 233: Kavität
- 216: Kanal
- 218, 219: mikromechanische Geometrien
- 220, 230: Einbettungsschicht
- 240: Strukturwafer
- 250: Elektrodenschicht
- 260, 270: Deckelwafer

## Patentansprüche

1. Bauelement aufweisend:
- ein Substrat (100) mit einer ersten Kavität (112) und einer zweiten Kavität (113);
- wobei in der ersten Kavität (112) eine erste mikromechanischer Struktur (117) angeordnet ist;
- wobei in der zweiten Kavität (113) eine zweite mikromechanische Struktur (118) angeordnet ist;
- wobei die erste Kavität (112) einen ersten Gasdruck aufweist;
- wobei die zweite Kavität (113) einen zweiten Gasdruck aufweist;
- wobei der erste Gasdruck durch Verschließen der ersten Kavität (112) bereitgestellt wird;
- wobei ein erster Kanal (115) in die zweite Kavität (113) mündet, und der zweite Gasdruck über den ersten Kanal (115) einstellbar ist; und
- der zweite Gasdruck unterschiedlich vom ersten Gasdruck ist,
**dadurch gekennzeichnet, dass** die zweite mikromechanische Struktur (118), angeordnet in der zweiten Kavität (113), auf Waferebene mit einem Waferbondverfahren verschließbar ist.

2. Bauelement nach Anspruch 1, wobei das Substrat (100) eine Mehrzahl von Substratschichten (110, 120, 130, 140, 160, 170) aufweist, die in Form von Wafer-Schichten ausgebildet sind, und mindestens eine Substratschicht (110, 120, 130, 140, 160, 170) einen Verschlusswafer (170) aufweist.

3. Bauelement nach einem der Ansprüche 1 oder 2, wobei mindestens eine der mikromechanischen Strukturen (117, 18) ein Inertialsensor, insbesondere ein Beschleunigungssensor oder ein Drehratensensor, ist.

4. Bauelement, nach einem der Ansprüche 1 bis 3, wobei das Substrat (100) eine dritte Kavität (114) aufweist, wobei in der dritten Kavität (114) eine dritte mikromechanische Struktur (119) angeordnet ist und ein dritter Gasdruck in der dritten Kavität (114) über einen zweiten Kanal (116) einstellbar ist.

5. Bauelement nach Anspruch 4, wobei ein erstes Ende des ersten Kanals (115) an einer ersten Substratschicht (160) endet und ein zweites Ende des zweiten Kanals (116) an einer zweiten Substratschicht (170) endet.

6. Bauelement nach einem der Ansprüche 1 bis 5, **dadurch gekennzeichnet, dass** das Bauelement ein Mikrochip ist, der in einem Fahrzeug, insbesondere in einem Kraftfahrzeug, verwendbar ist.

7. Verfahren zur Herstellung eines Bauelementes durch
- Bereitstellen eines Substrats (100), das eine erste Kavität (112) und eine zweite Kavität (113) aufweist;
- Anordnen einer ersten mikromechanischen Struktur (117) in der ersten Kavität (112);
- Anordnen einer zweiten mikromechanischen Struktur (118) in der zweiten Kavität (113);
- Einstellen eines ersten Gasdrucks in der ersten Kavität (112) durch Verschließen der ersten Kavität (112);
- Anordnen eines ersten Kanals (115) an der zweiten Kavität (113); und
- Einstellen des zweiten Drucks in der zweiten Kavität (113) durch Verschließen des ersten Kanals (115),
**dadurch gekennzeichnet, dass** das Verschließen mindestens eines Kanals (115, 116) mit einem Waferbondenverfahren durchgeführt wird.

8. Verfahren zur Herstellung eines Bauelements nach Anspruch 7, aufweisend
- Bereitstellen einer dritten Kavität (114) in dem Substrat (110);
- Anordnen einer dritten mikromechanischen Struktur (119) in der dritten Kavität (113);
- Einstellen eines dritten Gasdrucks in der dritten Kavität (113) durch Verschließen der dritten Kavität (113);
- Anordnen eines zweiten Kanals (116) an der dritten Kavität (113); und
- Einstellen eines dritten Drucks in der dritten Kavität (113) durch Verschließen des zweiten Kanals (116).

## Claims

1. Component comprising:
- a substrate (100) having a first cavity (112) and a second cavity (113);
- wherein a first micromechanical structure (117) is arranged in the first cavity (112);
- wherein a second micromechanical structure (118) is arranged in the second cavity (113);
- wherein the first cavity (112) has a first gas pressure;
- wherein the second cavity (113) has a second gas pressure;
- wherein the first gas pressure is provided by closing off the first cavity (112);
- wherein a first channel (115) opens into the second cavity (113), and the second gas pressure is adjustable via the first channel (115); and
- the second gas pressure is different from the first gas pressure,
**characterized in that** the second micromechanical structure (118), arranged in the second cavity (113), can be closed off at the wafer level by means of a wafer bonding method.

2. Component according to Claim 1, wherein the substrate (100) comprises a plurality of substrate layers (110, 120, 130, 140, 160, 170) embodied in the form of wafer layers, and at least one substrate layer (110, 120, 130, 140, 160, 170) comprises a closure wafer (170).

3. Component according to either of Claims 1 and 2, wherein at least one of the micromechanical structures (117, 18) is an inertial sensor, in particular an acceleration sensor or a rate-of-rotation sensor.

4. Component according to any of Claims 1 to 3, wherein the substrate (100) has a third cavity (114), wherein a third micromechanical structure (119) is arranged in the third cavity (114) and a third gas pressure is adjustable in the third cavity (114) via a second channel (116).

5. Component according to Claim 4, wherein a first end of the first channel (115) ends at a first substrate layer (160) and a second end of the second channel (116) ends at a second substrate layer (170).

6. Component according to any of Claims 1 to 5, **characterized in that** the component is a microchip which can be used in a vehicle, in particular in a motor vehicle.

7. Method for producing a component by
- providing a substrate (100) having a first cavity (112) and a second cavity (113);
- arranging a first micromechanical structure (117) in the first cavity (112);
- arranging a second micromechanical structure (118) in the second cavity (113);
- setting a first gas pressure in the first cavity (112) by closing off the first cavity (112);
- arranging a first channel (115) at the second cavity (113); and
- setting the second pressure in the second cavity (113) by closing off the first channel (115),
**characterized in that** the closing-off of at least one channel (115, 116) is carried out by means of a wafer bonding method.

8. Method for producing a component according to Claim 7, comprising
- providing a third cavity (114) in the substrate (110);
- arranging a third micromechanical structure (119) in the third cavity (113);
- setting a third gas pressure in the third cavity (113) by closing off the third cavity (113);
- arranging a second channel (116) at the third cavity (113); and
- setting a third pressure in the third cavity (113) by closing off the second channel (116).

## Revendications

1. Composant présentant :
un substrat (100) doté d'une première cavité (112) et d'une deuxième cavité (113),
une première structure micromécanique (117) étant disposée dans la première cavité (112),
une deuxième structure micromécanique (118) étant disposée dans la deuxième cavité (113),
la première cavité (112) présentant une première pression de gaz,
la deuxième cavité (113) présentant une deuxième pression de gaz,
la première pression de gaz étant établie par fermeture de la première cavité (112),
un premier canal (115) débouchant dans la deuxième cavité (113) et la deuxième pression de gaz pouvant être ajustée par l'intermédiaire du premier canal (115),
la deuxième pression de gaz étant différente de la première pression de gaz,
**caractérisé en ce que**
la deuxième structure micromécanique (118) disposée dans la deuxième cavité (113) peut être fermée sur le plan de la galette par une opération de liaison de galette.

2. Composant selon la revendication 1, dans lequel le substrat (100) présente plusieurs couches de substrat (110, 120, 130, 140, 160, 170) configurées sous la forme de couches de galette, au moins une couche de substrat (110, 120, 130, 140, 160, 170) présentant une galette de fermeture (170).

3. Composant selon l'une des revendications 1 ou 2, dans lequel au moins l'une des structures micromécaniques (117, 118) est un capteur inertiel et en particulier un capteur d'accélération ou un capteur de vitesse de rotation.

4. Composant selon l'une des revendications 1 à 3, dans lequel le substrat (100) présente une troisième cavité (114), une troisième structure micromécanique (119) étant disposée dans la troisième cavité (114) et une troisième pression de gaz pouvant être établie dans la troisième cavité (114) par l'intermédiaire d'un deuxième canal (116).

5. Composant selon la revendication 4, dans lequel une première extrémité du premier canal (115) se termine sur une première couche de substrat (160) et une deuxième extrémité du deuxième canal (116) sur une deuxième couche de substrat (170).

6. Composant selon l'une des revendications 1 à 5, **caractérisé en ce que** le composant est une micropuce qui peut être utilisée dans un véhicule et en particulier un véhicule automobile.

7. Procédé de fabrication d'un composant par :
préparation d'un substrat (100) qui présente une première cavité (112) et une deuxième cavité (113),
agencement d'une première structure micromécanique (117) dans la première cavité (112),
agencement d'une deuxième structure micromécanique (118) dans la deuxième cavité (113),
établissement d'une première pression de gaz dans la première cavité (112) par fermeture de la première cavité (112),
agencement d'un premier canal (115) sur la deuxième cavité (113) et
ajustement de la deuxième pression dans la deuxième cavité (113) par fermeture du premier canal (115),
**caractérisé en ce que**
la fermeture d'au moins un canal (115, 116) est réalisée par une opération de liaison de galette.

8. Procédé de fabrication d'un composant selon la revendication 7, présentant les étapes qui consistent à :
réaliser une troisième cavité (114) dans le substrat (110),
agencer une troisième structure micromécanique (119) dans la troisième cavité (113),
établir une troisième pression de gaz dans la troisième cavité (113) par fermeture de la troisième cavité (113),
agencer un deuxième canal (116) sur la troisième cavité (113) et
établir une troisième pression dans la troisième cavité (113) par fermeture du deuxième canal (116).
